# EUROPEAN PATENT SPECIFICATION

(11) **EP 2 146 557 B1**
(45) Date of publication and mention of the grant of the patent: **16.05.2012**
(21) Application number: 09164411.2
(22) Date of filing: 02.07.2009
(51) Int. Cl.: H05K 1/02

(54) **Integrated microwave circuit**
Integrierte Mikrowellenschaltung
Circuit à micro-ondes intégrées

(30) Priority: 15.07.2008 GB 0812911
(43) Date of publication of application: 20.01.2010
(73) Proprietor: Thales Holdings UK Plc, Addlestone, Surrey KT15 2NX (GB)
(72) Inventor: Lawson, Graham, CRAWLEY, Sussex RH11 0LX (GB); Loiselet, Emmanuel, HORSHAM, Sussex RH13 5LE (GB)
(74) Representative: Round, Edward Mark

(56) References cited:
- EP-A- 1 307 078
- FR-A- 2 849 346
- US-A1- 2005 098 348

## Description

This invention relates to an hermetically sealed integrated microwave circuit comprising a waveguide on a PCB, printed circuit board, electrically connected on one major surface to an IC, integrated circuit, and thermally and electrically connected to a BGA, ball grid array, on its opposite major surface.

Difficulties with such integrated circuit structures for microwave signals arise in the RF transition between layers. The purpose of the present invention is to drive a radio frequency, RF, signal from internal layers of a PCB motherboard to a micro BGA component mounted on the upper face of the motherboard, with good RF performance, and satisfactory insertion losses and return losses. It has been difficult to provide a satisfactory RF transition whilst maintaining hermetic seals for the package, and good reliability in use, particularly with thermal stress and vibration.

A document EP-A-1 307 078 discloses a high-frequency circuit module. A document US 2005/0098348 A1 discloses a high-frequency signal transmitting device.

Accordingly, the present invention provides an hermetically sealed integrated microwave circuit comprising a coplanar waveguide on a PCB electrically connected on one major surface to an IC, and thermally and electrically connected to a BGA on its opposite major surface, in which the PCB has at least first and second printed layers, a microwave signal path extends from a ball of the BGA through a through-hole in both printed layers to the coplanar waveguide, and plural ground paths extend from balls of the BGA through first through-holes in the first printed layer of the PCB and through second through-holes of the second printed layer of the PCB, the first and second through-holes being non-coincident, to allow for an hermetic seal across the PCB whilst introducing a predetermined impedance in the PCB between the signal and ground paths.

This novel combination of a PCB with a coplanar waveguide structure, offset through-holes and a BGA provides a good RF transition for microwaves through the PCB whilst maintaining reliable hermetic sealing.

In order that the invention may be better understood, a preferred embodiment will now be described, by way of example only, with reference to the accompanying drawings, in which:
Figure 1 is a perspective view, partly broken away, of an hermetically sealed box embodying the invention, containing integrated circuits and having on its underside a BGA;
Figure 2 is an exploded perspective view of two joined PCBs of the example shown in Figure 1;
Figure 3 shows four printed surface layers of the PCBs of Figures 1 and 2 illustrating the through-holes and the signal paths to the BGA;
Figure 4 is a diagram showing a conventional coplanar waveguide;
Figure 5 is a cross-section through a conventional IC assembly, corresponding to portion 61 of Figure 6;
Figure 6 is a partial perspective view of a radar antenna array having transmit/receive modules including hermetically sealed boxes 1 of the type shown in Figure 1 and Figure 5;
Figure 7 is a diagram showing a sealed box on a test array;
Figure 8 is a perspective view, partially broken away, of an hermetically sealed box 1 a similar to box 1 of Figure 1; and
Figure 9 is a perspective exploded view of the components of the box 1 a of Figure 8, connected to a BGA.

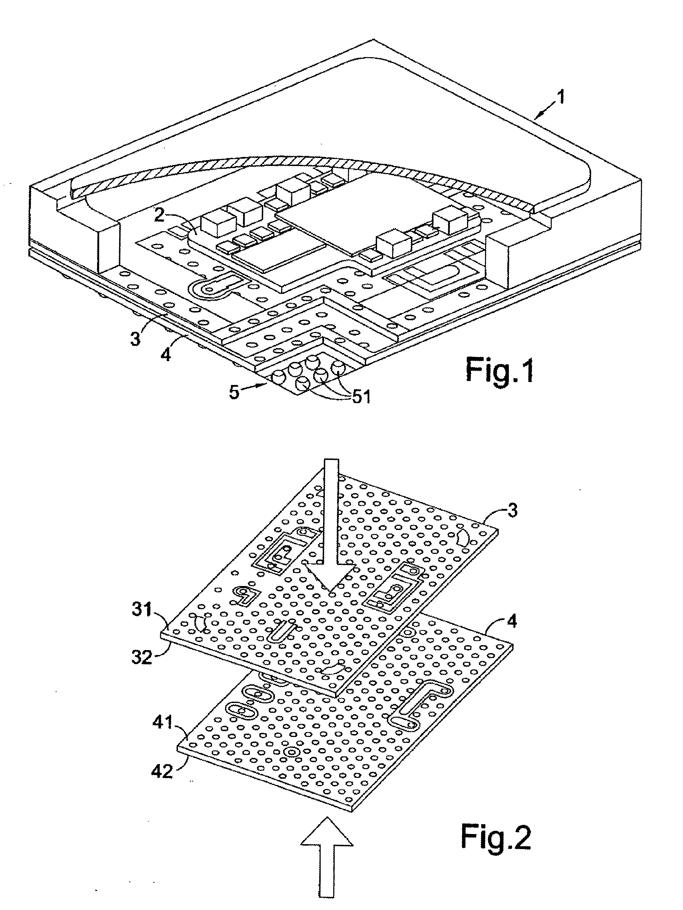

A micro BGA package for microwave RF comprising an hermetically sealed box 1 is shown in Figure 1, and its underside is bonded to a BGA 5 comprising solder balls 51. The package has a multiplicity of integrated circuits on a substrate 2 bonded to the printed circuits of a PCB structure comprising two separate PCBs 3, 4 shown in greater detail in Figure 2. The upper major surface 31 of PCB 3 is connected electrically and thermally to the various ICs above it. The underside layer 32 of PCB 3 is bonded to a corresponding upper layer 41 of the PCB 4, whose undersurface 42 is bonded to the BGA 5.

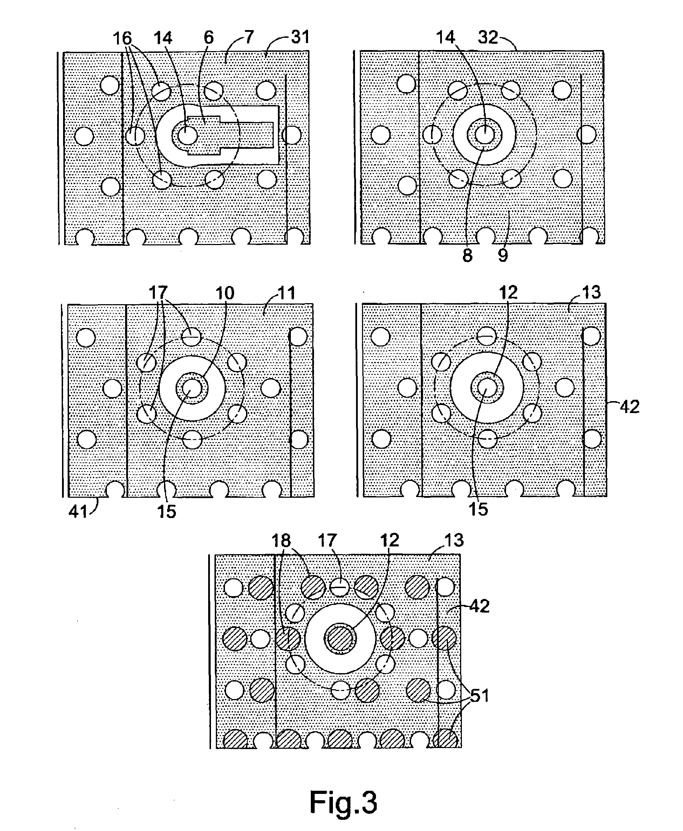

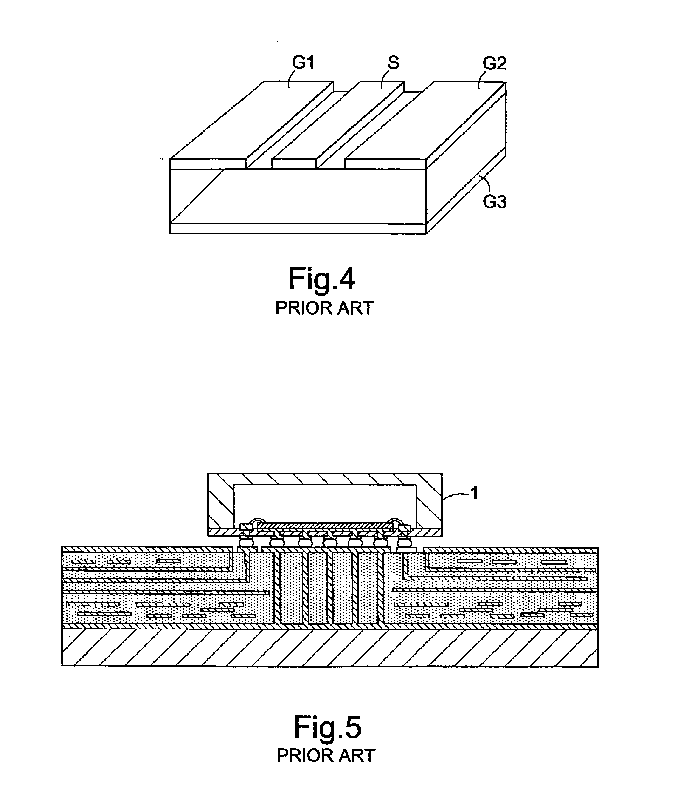

A microwave signal is transmitted across the upper major surface 31 in a signal path 6 shown in Figure 3 which ends at a through-hole 14 extending through the top PCB 3 and in register with a corresponding through-hole 15 in the lower PCB 4, the through-hole 15 being surrounded by a ring shaped conductive pattern 10. This signal path structure is an example of a coplanar waveguide which in itself is well known and is illustrated in Figure 4. The coplanar waveguide has a signal path S spaced on each side from ground paths G1, G2, and spaced by the thickness of the board from a further ground path G3.

A ground connection is made through metallic layer 7 on the upper surface 31, and corresponding metallic layers 9, 11 and 13 in the layers 32, 41 and 42 as shown in Figure 3. The ground layers communicate using arrays of through-holes 16, 17 through the respective PCBs 3, 4. These electrically shield the signal path and the entire structure introduces a predetermined impedance, at the RF microwave frequencies which may for example be in the 4 to 20 GHz bandwidth. This impedance may be nominally 50Ω, and is preferably in the range 10 to 100Ω, more preferably 30 to 80Ω.

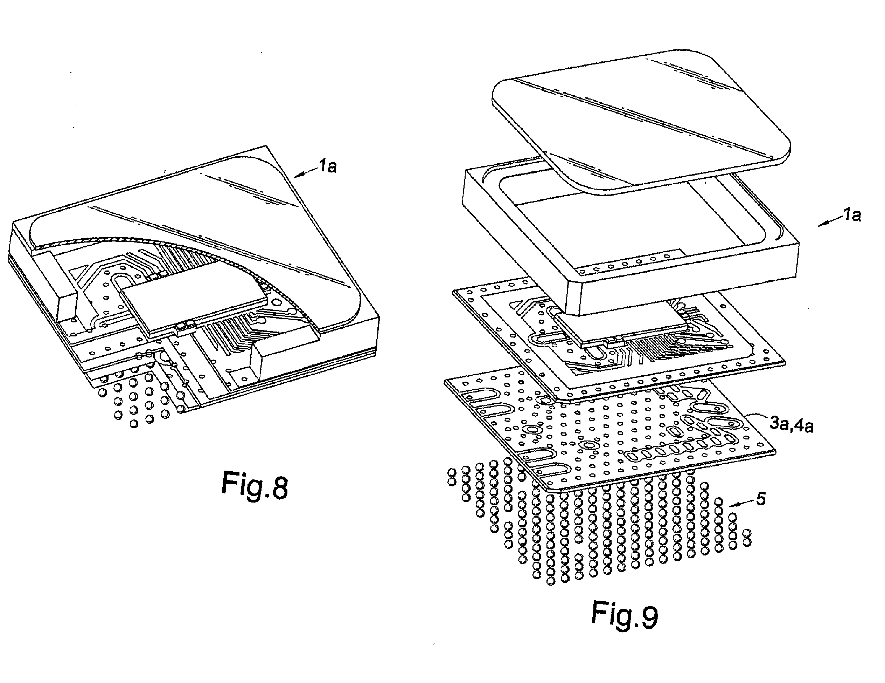

The BGA 5 forms a regular grid pattern, as shown in Figure 3, and as illustrated in the further embodiment of Figures 8 and 9 described below. In this example, it is a diagonal grid with a pitch of about 0.8 mm and a 0.4 mm offset. The balls of the BGA are each 400µm in diameter and in other examples are preferably in the range of 300 to 500µm in diameter.

The set of through-holes 16 form a circular array around the signal path extending through the through-hole 14, 15, as shown in Figure 3. There is a second set of through-holes 17 in the lower PCB 4, and the two circular arrays are opposed, with the same radius. However, the through-holes 16 are rotationally offset from the through-holes 17, so that they are in register with the midpoints of adjacent through-holes. In this example, the layer 31 has five through-holes 16, with a gap on the right hand side where a through-hole is redundant because it would cross the signal path of the coplanar waveguide. Four of these through-holes 16 are continued through the undersurface 32 of PCB 3. The upper major surface 41 of the lower PCB 4 has six equi-angularly disposed through-holes 17, precisely offset from the through-holes 16; these through-holes 17 also extend through the undersurface 42 to the plane of the BGA 5 as shown in Figure 3. Since the balls of the BGA are in a diagonal rectangular grid, they cannot be selected to form precisely circular arrays of balls, but selected balls 18, shown in Figure 3, can be in a nearly circular array to be bonded to the metal layer 13 quite close to the midpoints between adjacent through-holes 17 in the circular array.

Thus it will be appreciated that the signal path extends through the centres of the circular arrays of through-holes for the ground connection. The diameter of each ball of the BGA is less than the distance between adjacent through-holes of the PCB.

It will be appreciated that a good hermetic seal can be achieved between the two PCB layers, due to the offsets in the through-holes. The bonding between the PCBs, which may for example be RF organic substrates of Rogers RO 4003 material coated with gold or tin layers, preferably uses intra-metallic diffusion processes under high pressure. Intra-metallic diffusion soldering between the metal layers ensures very good thermal conductivity, as well as good hermetic sealing.

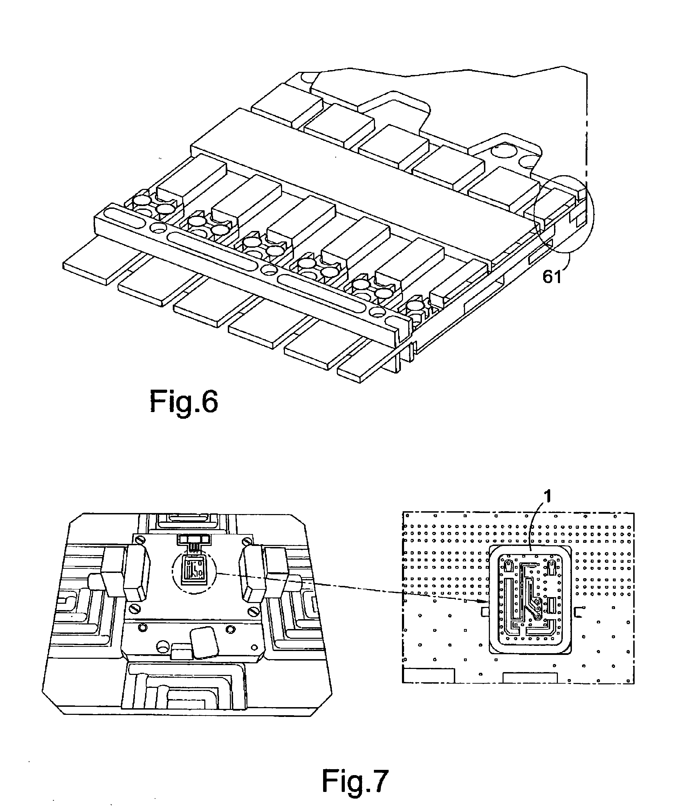

To illustrate the application of hermetically sealed packages embodying the invention, a radar antenna array structure is shown in Figure 6, part 61 of which corresponds to the sectional view of Figure 5. The transmit/receive module of this antenna circuit has several high power amplifiers in hermetically sealed boxes such as box 1 shown in Figure 7. The overall structure provides good thermal heat dissipation from these amplifiers. A sealed box 1 a embodying the invention and similar to box 1 of Figure 1 is shown in Figures 8 and 9, which further illustrate the multi-layer PCB structure 3a, 4a adjoining a BGA 5.

## Claims

1. An hermetically sealed integrated microwave circuit comprising a coplanar waveguide on a PCB (3, 4) electrically connected on one major (31) surface to an IC, and thermally and electrically connected to a BGA (5) on its opposite major surface, the PCB having at least first and second printed layers (31, 32, 41, 42), a microwave signal path (6) extends from a ball of the BGA (5) through a through-hole (14, 15) in both printed layers to the coplanar wave guide, and plural ground paths extend from balls (51) of the BGA (5) through first through-holes (16) in the first printed layer of the PCB and through second through-holes (17) of the second printed layer of the PCB, **characterized in that** the first and second through-holes are non-coincident, to allow for a hermetic seal across the PCB whilst introducing a predetermined impedance in the PCB between the signal and ground paths.

2. A circuit according to Claim 1, in which the first through-holes (16) are in a circular array and the second through-holes (17) are in a circular array opposed to the first circular array but with the through-holes in rotational misalignment.

3. A circuit according to Claim 2, in which the through-hole (14, 15) through which the signal path passes is at the centre of the circular arrays of the first and second through-holes.

4. A circuit according to any preceding claim, in which the IC is connected by a further BGA to the said one major surface of the PCB.

5. A circuit according to any preceding claim, in which the diameter of each ball (51) of the BGA (5) on the said opposite major surface of the PCB is less than the distance between adjacent through-holes of the PCB.

6. A circuit according to any preceding claim, in which the through-holes have diameters in the range 200 to 400 µm.

7. A circuit according to any preceding claim, in which the balls of the said BGA are of diameters in the range 300 to 500 µm.

8. A circuit according to any preceding claim, in which the said BGA is a diagonal grid.

9. A circuit according to Claim 8, in which the BGA has a pitch of about 0.8mm with about 0.4mm offsets.

10. A circuit according to any preceding claim, in which the impedance between the signal path and the ground in the PCB is in the range 30Ω to 80Ω.

11. A circuit according to Claim 9, in which the said impedance is about 50Ω.

## Patentansprüche

1. Hermetisch abgedichtete integrierte Mikrowellenschaltung mit einem koplanaren Wellenleiter auf einer Leiterplatte (3, 4), die auf einer Hauptfläche (31) mit einer intergrierten Schaltung elektrisch verbunden ist und auf ihrer gegenüberliegenden Hauptfläche mit einem BGA (Gehäuse mit Kugelgitteranordnung) (5) thermisch und elektrisch verbunden ist, wobei die Leiterplatte mindestens erste und zweite gedruckte Schichten (31, 32, 41, 42) hat, ein Mikrowellen-Signalweg (6) der sich von einer Lotperle bzw. Kugel des BGA (5) durch ein Durchgangsloch (14, 15) auf beiden gedruckten Schichten zu einem koplanaren Hohlleiter erstreckt und mehrere Erdungswege sich von Lotperlen (51) des BGA (5) durch erste Durchgangslöcher (16) in der ersten gedruckten Schicht der Leiterplatte und durch zweite Durchgangslöcher (17) der zweiten gedruckten Schicht der Leiterplatte erstrecken, **dadurch gekennzeichnet, dass** die ersten und zweiten Durchgangslöcher nicht deckungsgleich sind, um für eine hermetische Abdichtung über die Leiterplatte hinweg zu sorgen und gleichzeitig einen vorbestimmten Widerstand der Leiterplatte zwischen den Signal- und Erdungswegen einzubringen.

2. Schaltung nach Anspruch 1, bei der die ersten Durchgangslöcher (16) in einer kreisförmigen Anordnung und die zweiten Durchgangslöcher (17) in einer kreisförmigen Anordnung gegenüber der ersten kreisförmigen Anordnung sind, wobei die Durchgangslöcher allerdings in Drehrichtung versetzt sind.

3. Schaltung nach Anspruch 2, bei der das Durchgangsloch (14, 15), durch das der Signalweg verläuft, sich im Zentrum der kreisförmigen Anordnungen der ersten und zweiten Durchgangslöcher befindet.

4. Schaltung nach einem der vorhergehenden Ansprüche, bei dem die integrierte Schaltung durch ein weiteres BGA mit der einen Hauptfläche der Leiterplatte verbunden ist.

5. Schaltung nach einem der vorhergehenden Ansprüche, bei der der Durchmesser jeder Lotperle (51) des BGA (5) auf der gegenüberliegenden Hauptfläche der Leiterplatte kleiner ist als der Abstand zwischen benachbarten Durchgangslöchern der Leiterplatte.

6. Schaltung nach einem der vorhergehenden Ansprüche, bei der die Durchgangslöcher Durchmesser im Bereich von 200 bis 400 µm haben.

7. Schaltung nach einem der vorhergehenden Ansprüche, bei der die Lotperlen des BGA Durchmesser im Bereich von 300 bis 500 µm haben.

8. Schaltung nach einem der vorhergehenden Ansprüche, bei der das BGA ein diagonales Gitter ist.

9. Schaltung nach Anspruch 8, bei der das BGA ein Rastermaß von etwa 0,8 mm und Versetzungen von etwa 0,4 mm aufweist.

10. Schaltung nach einem der vorhergehenden Ansprüche, bei der der Widerstand zwischen dem Signalweg und der Erdung in der Leiterplatte im Bereich von 30 Ω auf 80 Ω liegt.

11. Schaltung nach Anspruch 9, bei der der Widerstand etwa 50 Ω beträgt.

## Revendications

1. Circuit intégré hyperfréquence enfermé hermétiquement comprenant un guide d'ondes coplanaire sur une PCB (3, 4) connectée électriquement sur une surface majeure (31) à un circuit intégré, et connectée thermiquement et électriquement à un BGA (5) sur sa surface majeure opposée, la PCB comportant au moins des première et deuxième couches imprimées (31, 32, 41, 42), un trajet de signal hyperfréquence (6) s'étendant d'une bille du BGA (5) à travers un trou traversant (14, 15) dans les deux couches imprimées vers le guide d'ondes coplanaire, et plusieurs trajets de masse s'étendant de billes (51) du BGA (5) à travers des premiers trous traversants (16) dans la première couche imprimée de la PCB et à travers des deuxièmes trous traversants (17) de la deuxième couche imprimée de la PCB, **caractérisé en ce que** les premiers et deuxièmes trous traversants ne coïncident pas, afin de permettre l'obtention d'une étanchéité à travers la PCB alors qu'une impédance prédéterminée est introduite dans la PCB entre les trajets de signal et de masse.

2. Circuit selon la revendication 1, dans lequel les premiers trous traversants (16) sont disposés en un ensemble circulaire et les deuxièmes trous traversants (17) sont disposés en un ensemble circulaire opposé au premier ensemble circulaire, mais avec les trous traversants non alignés dans le sens de la rotation.

3. Circuit selon la revendication 2, dans lequel le trou traversant (14, 15) à travers lequel le trajet de signal passe est au centre des ensembles circulaires des premiers et deuxièmes trous traversants.

4. Circuit selon l'une quelconque des revendications précédentes, dans lequel le circuit intégré est connecté par un autre BGA à ladite une surface majeure de la PCB.

5. Circuit selon l'une quelconque des revendications précédentes, dans lequel le diamètre de chaque bille (51) du BGA (5) sur ladite surface majeure opposée de la PCB est inférieur à la distance entre les trous traversants adjacents de la PCB.

6. Circuit selon l'une quelconque des revendications précédentes, dans lequel les trous traversants ont des diamètres dans la plage de 200 à 400 µm.

7. Circuit selon l'une quelconque des revendications précédentes, dans lequel les billes dudit BGA ont des diamètres dans la plage de 300 à 500 µm.

8. Circuit selon l'une quelconque des revendications précédentes, dans lequel ledit BGA est une grille en diagonale.

9. Circuit selon la revendication 8, dans lequel le BGA a un pas d'environ 0,8 mm avec des décalages d'environ 0,4 mm.

10. Circuit selon l'une quelconque des revendications précédentes, dans lequel l'impédance entre le trajet de signal et la masse dans la PCB est dans la plage de 30 Ω à 80 Ω.

11. Circuit selon la revendication 9, dans lequel ladite impédance est d'environ 50 Ω.
